# EUROPEAN PATENT APPLICATION

(11) **EP 4 658 013 A1**
(43) Date of publication of application: **03.12.2025**
(21) Application number: 25161238.8
(22) Date of filing: 03.03.2025
(51) Int. Cl.: H10B 12/00

(54) **SEMICONDUCTOR DEVICES**

(30) Priority: 29.05.2024 KR 20240070048
(71) Applicant: Samsung Electronics Co., Ltd., Suwon-si, Gyeonggi-do 16677 (KR)
(72) Inventor: PARK, Taejin, Suwon-si, Gyeonggi-do 16677 (KR); SHIN, Suyoung, Suwon-si, Gyeonggi-do 16677 (KR); SHIN, Euijoong, Suwon-si, Gyeonggi-do 16677 (KR); YOON, Ilyoung, Suwon-si, Gyeonggi-do 16677 (KR); LEE, Hosang, Suwon-si, Gyeonggi-do 16677 (KR); YIM, Sungsoo, Suwon-si, Gyeonggi-do 16677 (KR); CUI, Hao, Suwon-si, Gyeonggi-do 16677 (KR)
(74) Representative: Kuhnen & Wacker Patent- und Rechtsanwaltsbüro PartG mbB

(57) **Abstract**

A semiconductor device includes a peripheral circuit pattern on a substrate including first and second regions, a bit line structure on the peripheral circuit pattern electrically connected to the peripheral circuit pattern on the first region of the substrate, a channel on and electrically connected to the bit line structure, a word line at a side of the channel, a capacitor on and electrically connected to the channel, a plate electrode on an upper surface and a sidewall of the capacitor, an etch stop pattern on the second region of the substrate, and a first through via on and electrically connected to the peripheral circuit pattern on the second region of the substrate. A lower surface of the etch stop pattern is coplanar with a lower surface of the channel, and the first through via extends through the etch stop pattern in a vertical direction, and contacts the plate electrode.

## Description

### CROSS-REFERENCE TO RELATED APPLICATION

This application claims priority to Korean Patent Application No. 10-2024-0070048 filed on May 29, 2024 in the Korean Intellectual Property Office, the disclosure of which is hereby incorporated by reference in its entirety.

### BACKGROUND

Example embodiments of the present disclosure relate generally to a semiconductor device. More particularly, example embodiments of the present disclosure relate to a memory device including a vertical channel.

In order to improve an integration degree of a semiconductor device, a memory device including a vertical channel transistor has been developed. In the vertical channel memory device, memory cells and peripheral circuit patterns are formed on different substrates, respectively, and the substrates may be bonded with each other. Silicon-on-insulator (SOI) substrates may be used in the vertical channel memory device, however, the SOI substrates are expensive.

### SUMMARY

Example embodiments provide a semiconductor device having improved characteristics.

According to example embodiments, there is provided a semiconductor device that may include a peripheral circuit pattern, a bit line structure, a channel, a word line, a capacitor, a plate electrode, an etch stop pattern, and a first through via. The peripheral circuit pattern may be on a substrate including a first region and a second region surrounding (i.e., extending around) the first region. The bit line structure may be on the peripheral circuit pattern on the first region of the substrate, and may be electrically connected to the peripheral circuit pattern. The channel may be on the bit line structure, and may be electrically connected to the bit line structure. The word line may be at a side of the channel. The capacitor may be on the channel, and may be electrically connected to the channel. The plate electrode may be on an upper surface and a sidewall of the capacitor. The etch stop pattern may be on the second region of the substrate, and a lower surface of the etch stop pattern may be substantially coplanar with a lower surface of the channel. The first through via may be on the peripheral circuit pattern on the second region of the substrate, and may be electrically connected to the peripheral circuit pattern. The first through via may extend through the etch stop pattern in a vertical direction substantially perpendicular to an upper surface of the substrate, and may contact the plate electrode.

According to example embodiments, there is provided a semiconductor device that may include a peripheral circuit pattern, a first insulating interlayer, a bonding layer structure, bit line structures, a second insulating interlayer, channels, first gate structures, second gate structures, contact plugs, landing pad structures, a capacitor, a plate electrode, an etch stop pattern, a first insulation pattern and a through via. The peripheral circuit pattern may be on a substrate including a first region and a second region surrounding the first region. The first insulating interlayer may be on the substrate, and may cover the peripheral circuit pattern. The bonding layer structure may be on the first insulating interlayer, and may include a bonding pattern structure. The bit line structures may be on the bonding layer structure on the first region of the substrate, and may be electrically connected to the boding pattern structure. Each of the bit line structures may extend in a first direction substantially parallel to an upper surface of the substrate, and the bit line structures may be spaced apart from each other in a second direction substantially parallel to the upper surface of the substrate and crossing the first direction. The second insulating interlayer may be on the bonding layer structure, and may cover sidewalls of the bit line structures. The channels may contact an upper surface of each of the bit line structures, and may be spaced apart from each other in the first direction. The first gate structures may be on the bit line structures and the second insulating interlayer, and each of the first gate structures may extend in the second direction. The first gate structures may contact first sidewalls in the first direction of a subset of the channels disposed in the second direction. The second gate structures may be on the bit line structures and the second insulating interlayer, and each of the second gate structures may extend in the second direction. The second gate structures may contact second sidewalls in the first direction of the subset of the channels in the second direction. The contact plugs may be on the channels, respectively. The landing pad structures may be on the contact plugs, respectively. The capacitor may be on the landing pad structures, and may be electrically connected to the landing pad structures. The plate electrode may be on an upper surface and a sidewall of the capacitor. The etch stop pattern may be on the second region of the substrate, and may contact an upper surface of the second insulating interlayer. The first insulation pattern may be on the etch stop pattern. The through via may be on the second region of the substrate, and may extend through the second insulating interlayer, the etch stop pattern and the first insulation pattern in a vertical direction substantially perpendicular to the upper surface of the substrate. The through via may contact the plate electrode.

According to example embodiments, there is provided a semiconductor device that may include a peripheral circuit pattern, a first insulating interlayer, a bonding layer structure, bit line structures, a second insulating interlayer, channels, first gate structures, second gate structures, contact plugs, landing pad structures, a capacitor, a plate electrode, an etch stop pattern, a first insulation pattern and a through via. The peripheral circuit pattern may be on a substrate including a first region and a second region surrounding (i.e., extending around) the first region. The first insulating interlayer may be disposed on the substrate, and may cover the peripheral circuit pattern. The bonding layer structure may be on the first insulating interlayer, and may include a bonding pattern structure. The bit line structures may be on the bonding layer structure on the first region of the substrate, and may be electrically connected to the boding pattern structure. Each of the bit line structures may extend in a first direction substantially parallel to an upper surface of the substrate, and the bit line structures may be spaced apart from each other in a second direction substantially parallel to the upper surface of the substrate and crossing the first direction. The second insulating interlayer may be on the bonding layer structure, and may cover sidewalls of the bit line structures. The channels may contact an upper surface of each of the bit line structures, and may be spaced apart from each other in the first direction. The first gate structures may be on the bit line structures and the second insulating interlayer, and each of the first gate structures may extend in the second direction. The first gate structures may contact first sidewalls in the first direction of a subset of the channels disposed in the second direction. The second gate structures may be on the bit line structures and the second insulating interlayer, and each of the second gate structures may extend in the second direction. The second gate structures may contact second sidewalls in the first direction of the subset of the channels disposed in the second direction. The contact plugs may be on the channels, respectively. The landing pad structures may be on the contact plugs, respectively. The capacitor may be on the landing pad structures, and may be electrically connected to the landing pad structures. The plate electrode may be on an upper surface and a sidewall of the capacitor. The etch stop pattern may be on the second region of the substrate, and may contact an upper surface of the second insulating interlayer. The first insulation pattern may be on the etch stop pattern. The through via may be on the second region of the substrate, and may extend through the second insulating interlayer, the etch stop pattern and the first insulation pattern in a vertical direction substantially perpendicular to the upper surface of the substrate. The through via may contact the plate electrode.

In a method of manufacturing the semiconductor device in accordance with example embodiments, the etch stop layer on the extension region of the substrate may be used as an end point of a polishing process, even without using an expensive SOI substrate, so as to reduce the length distribution of the gate structures. Thus, the semiconductor device may have enhanced electrical characteristics.

### BRIEF DESCRIPTION OF THE DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:
FIG. 1 is a schematic cross-sectional view illustrating a semiconductor device in accordance with example embodiments;
FIGS. 2 to 21 are schematic plan views and schematic cross-sectional views illustrating intermediate processes in a method of manufacturing a semiconductor device in accordance with example embodiments;
FIG. 22 is a schematic cross-sectional view illustrating a method of manufacturing a semiconductor device in accordance with example embodiments;
FIGS. 23 and 24 are schematic cross-sectional views illustrating a method of manufacturing a semiconductor device in accordance with example embodiments;
FIGS. 25 and 26 are schematic cross-sectional views illustrating semiconductor devices in accordance with example embodiments; and
FIG. 27 is a schematic cross-sectional view illustrating a semiconductor device in accordance with example embodiments.

### DETAILED DESCRIPTION

The above and other aspects and features of a semiconductor device and a method of forming the same in accordance with example embodiments will become readily understood from detail descriptions that follow, with reference to the accompanying drawings. It will be understood that, although ordinal terms such as "first," "second," and/or "third" may be used herein to describe various materials, layers (films), regions, electrodes, pads, patterns, structures and processes, these materials, layers (films), regions, electrodes, pads, patterns, structures and processes should not be limited by these terms; that is, these ordinal terms are not necessarily intended to convey a particular order unless indicated otherwise. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

Hereinafter, in the specification (and not necessarily in the claims), two directions that are substantially perpendicular to each other among horizontal directions, which are substantially parallel to an upper surface of a substrate, may be referred to as first and second directions D1 and D2, respectively, and a vertical direction substantially perpendicular to the upper surface of the substrate may be referred to as a third direction D3. In example embodiments, the first and second directions D1 and D2 may be orthogonal to each other.

Each of the first to third directions D1, D2 and D3 may include not only a direction shown in the drawings but also a direction reverse thereto.

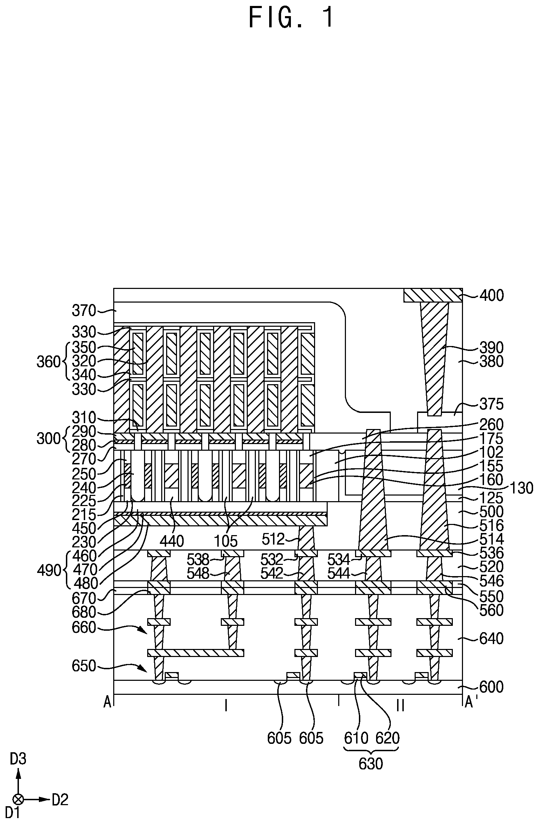

FIG. 1 is a schematic cross-sectional view illustrating a semiconductor device in accordance with example embodiments.

Referring to FIG. 1, the semiconductor device may include a peripheral circuit pattern 650 and memory cells that are stacked in the third direction D3 on a second substrate 600.

That is, the semiconductor device may have a cell-over-periphery (COP) structure. However, the inventive concept is not limited thereto, and the semiconductor device may have a periphery-over-cell (POC) structure by, e.g., flipping the semiconductor device shown in FIG. 1.

The semiconductor device may include first and second gate structures, a channel 105, a bit line structure 490, a capacitor 360, a plate electrode 370, a first contact plug 270, a landing pad structure 300, a first etch stop pattern 125, a second insulation pattern 130, the peripheral circuit pattern 650, and a wiring structure 660 on the second substrate 600.

The semiconductor device may further include third and fourth insulation patterns 230 and 240, first to fourth capping patterns 175, 250, 440 and 450, a semiconductor pattern 102, a second contact plug 512, first to third through vias 390, 514 and 516, first to fourth vias 542, 544, 546 and 548, first to fourth wirings 532, 534, 536 and 538, first to fifth insulating interlayers 260, 380, 500, 520 and 640, a second etch stop layer 310, a support layer 320, first and second conductive pads 375 and 400, third and fourth bonding layers 550 and 670, and first and second bonding patterns 560 and 680.

The second substrate 600 may include a first region I and a second region II surrounding the first region I. The term "surrounding" (or "surround," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. The first region I may be a cell array region in which the memory cells are formed, and the second region II may be an extension region in which through vias for transferring electrical signals to the memory cells are formed.

The second substrate 600 may include a semiconductor material, e.g., silicon, germanium, silicon-germanium, or a group III-V compound semiconductor, e.g., gallium phosphide (GaP), gallium arsenide (GaAs), gallium antimonide (GaSb), etc.

The peripheral circuit pattern 650 may include, e.g., a transistor, and the transistor may include, e.g., a third gate structure 630 on the second substrate 600 and source/drain regions 605 at upper portions, respectively, of the second substrate 600 adjacent thereto. The third gate structure 630 may include a third gate insulation pattern 610 and a third gate electrode 620 sequentially stacked in the third direction D3.

The peripheral circuit pattern 650 may be circuit patterns for, e.g., a bit line sense amplifier (BLSA), a sub-word line driver (SWD), a column decoder, a column select line (CSL) driver, an input/output sense amplifier (I/O SA), a write driver, etc.

The wiring structure 660 may be disposed on the second substrate 600, and may be electrically connected to the peripheral circuit pattern 650. The term "connected" (or "connecting," or like terms, such as "contact" or "contacting"), as may be used herein, is intended to refer to a physical and/or electrical connection between two or more elements, and may include other intervening elements. As used herein, the term "and/or" includes any and all combinations of one or more of the associated listed items. The wiring structure 660 may include, e.g., contact plugs, vias, wirings, etc.

The fifth insulating interlayer 640 may be disposed on the second substrate 600, and may cover the peripheral circuit pattern 650 and the wiring structure 660. The fifth insulating interlayer 640 may include, e.g., silicon oxide, silicon nitride, a low dielectric constant (low-k) dielectric material.

The fourth and third bonding layers 670 and 550 may be sequentially stacked on the fifth insulating interlayer 640 to form a bonding layer structure, and second and first bonding patterns 680 and 560 may be disposed in the fourth and third bonding layers 670 and 550, respectively, to form a bonding pattern structure. The first and second bonding patterns 560 and 680 may include a conductive material such as a metal, e.g., copper, and the third and fourth bonding layers 550 and 670 may include an insulating material, e.g., silicon carbonitride, silicon oxide, etc.

The first to fourth vias 542, 544, 546 and 548 may contact upper surfaces of corresponding ones of the first bonding patterns 560, respectively, and the first to fourth wirings 532, 534, 536 and 538 may contact upper surfaces of the first to fourth vias 542, 544, 546 and 548, respectively. The fourth insulating interlayer 520 may be disposed on the third bonding layer 550, and may cover sidewalls of the first to fourth vias 542, 544, 546 and 548 and the first to fourth wirings 532, 534, 536 and 538. The term "cover" (or "covers," or like terms), as may be used herein, is intended to broadly refer to an element, structure or layer that is on or over another element, structure or layer, either directly or with one or more other intervening elements, structures or layers therebetween. The fourth insulating interlayer 520 may include, e.g., silicon oxide, silicon nitride, a low-k dielectric material.

In example embodiments, each of the first to fourth vias 542, 544, 546 and 548 may have a horizontal width gradually increasing from a top toward a bottom thereof in the third direction D3 (i.e., as the first to fourth vias 542, 544, 546, 548 extend vertically downward toward the second substrate 600).

The second contact plug 512 may contact an upper surface of the first wiring 532.

The bit line structure 490 may extend in the second direction D2 on the first region I of the second substrate 600, and a plurality of bit line structures 490 may be spaced apart from each other in the first direction D1. The bit line structure 490 may contact an upper surface of the second contact plug 512.

In example embodiments, the bit line structure 490 may include fifth, fourth and third conductive patterns 480, 470 and 460, respectively, sequentially stacked in the third direction D3. The third conductive pattern 460 may include, e.g., doped polysilicon, the fourth conductive pattern 470 may include a metal silicide, e.g., titanium silicide, tungsten silicide, etc., and the fifth conductive pattern 480 may include a metal, e.g., tungsten, titanium, etc., or a metal nitride, e.g., titanium nitride.

The third insulating interlayer 500 may be disposed on the fourth insulating interlayer 520, and may cover sidewalls of the second contact plug 512 and the bit line structure 490. The third insulating interlayer 500 may include, e.g., silicon oxide, silicon nitride, a low-k dielectric material.

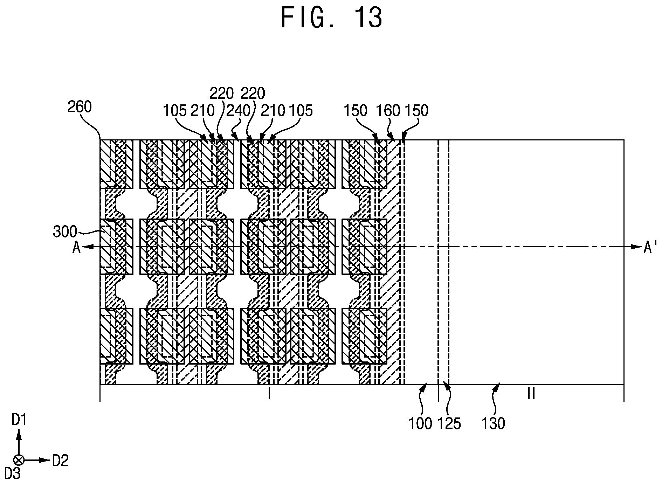

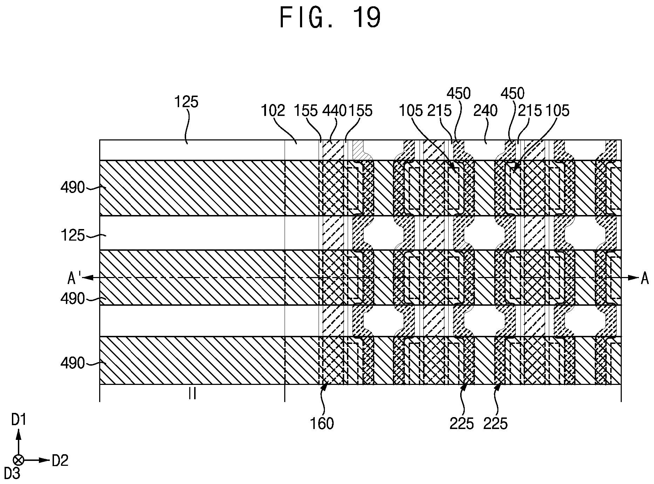

Referring to FIG. 1 together with FIGS. 13 and 19, a plurality of channels 105 may be spaced apart from each other in the second direction D2 on each of the bit line structures 490 extending in the second direction D2, and thus a plurality of channels 105 may be spaced apart from each other in each of the first and second directions D1 and D2. Each of the channels 105 may extend to a given length in the third direction D3.

The channel 105 may include a semiconductor material, e.g., silicon, germanium, silicon-germanium, etc.

The first gate structure may be disposed on the first region I of the second substrate 600, and may contact upper surfaces of the bit line structure 490 and the third insulating interlayer 500. The first gate structure may include a first gate electrode 160 extending in the first direction D1, and a first gate insulation pattern 155 extending in the first direction D1 on each of opposite sidewalls of the first gate electrode 160 in the second direction D2. The first gate insulation pattern 155 may contact a sidewall of the channel 105 in the second direction D2.

In example embodiments, the first gate electrode 160 may serve as a back gate of the semiconductor device.

The first gate electrode 160 may include a conductive material, e.g., a metal, a metal nitride, a metal silicide, etc., and the first gate insulation pattern 155 may include an oxide, e.g., silicon oxide.

The first and third capping patterns 175 and 440 may be on and beneath, respectively, the first gate electrode 160, and a lower surface of the third capping pattern 440 may contact the upper surface of the bit line structure 490. The first gate insulation pattern 155 may contact each of opposite sidewalls in the second direction D2 of each of the first and third capping patterns 175 and 440.

In example embodiments, an upper surface of the first capping pattern 175 may be substantially coplanar with upper surfaces of the first gate insulation pattern 155 and the channel 105, relative to an upper surface of the second substrate 600 as a reference layer, and a lower surface of the third capping pattern 440 may be substantially coplanar with lower surfaces of the first gate insulation pattern 155 and the channel 105, relative to the upper surface of the second substrate 600.

Each of the first and third capping patterns 175 and 440 may include an insulating nitride, e.g., silicon nitride.

The second gate structure may be disposed on the first region I of the second substrate 600, and may contact the upper surfaces of the bit line structure 490 and the third insulating interlayer 500. The second gate structure may include a second gate electrode 225 extending in the first direction D1, and a second gate insulation pattern 215 extending in the first direction D1 on each of opposite sidewalls of the second gate electrode 225 in the second direction D2. The second gate insulation pattern 215 may contact another sidewall in the second direction D2 and each of opposite sidewalls in the first direction D1 of the channel 105 and a portion of a sidewall of the first gate insulation pattern 155.

In example embodiments, each of the second gate electrode 225 and the second gate insulation pattern 215 may extend in the first direction D1, however, a sidewall of each of the second gate electrode 225 and the second gate insulation pattern 215 may not be in a straight line but have a winding shape in a plan view. In example embodiments, the second gate electrode 225 may serve as a word line of the semiconductor device.

The second gate electrode 225 may include a conductive material, e.g., a metal, a metal nitride, a metal silicide, etc., and the second gate insulation pattern 215 may include an oxide, e.g., silicon oxide.

The second and fourth capping patterns 250 and 450 may be on and beneath, respectively, the second gate electrode 225, and a lower surface of the fourth capping pattern 450 may contact the upper surface of the bit line structure 490. The second gate insulation pattern 215 may contact each of opposite sidewalls in the second direction D2 of each of the second and fourth capping patterns 250 and 450.

In example embodiments, an upper surface of the second capping pattern 250 may be substantially coplanar with upper surfaces of the second gate insulation pattern 215 and the channel 105 in the third direction D3, and a lower surface of the fourth capping pattern 450 may be substantially coplanar with lower surfaces of the second gate insulation pattern 215 and the channel 105 in the third direction D3.

Each of the second and fourth capping patterns 250 and 450 may include an insulating nitride, e.g., silicon nitride.

The fourth insulation pattern 240 may be disposed on the first region I of the second substrate 600, and may contact the upper surfaces of the bit line structure 490 and the third insulating interlayer 500. The fourth insulation pattern 240 may extend in the first direction D1, and may contact a sidewall of each of the second gate electrode 225 and the second and fourth capping patterns 250 and 450.

In example embodiments, each of opposite sidewalls in the second direction D2 of the fourth insulation pattern 240 may have a winding shape in the first direction D1 in a plan view. That is, a width in the second direction D2 of the fourth insulation pattern 240 may periodically vary in the first direction D1.

In an example embodiment, an entire portion of a lower surface of the fourth insulation pattern 240 may be substantially flat, and may contact the upper surface of the bit line structure 490. In this case, the third insulation pattern 230 may not be formed.

Alternatively, the lower surface of the fourth insulation pattern 240 may be convex downwardly, and only a central portion of the lower surface of the fourth insulation pattern 240 may contact the upper surface of the bit line structure 490. In this case, the third insulation pattern 230 may be disposed between the bit line structure 490 and an edge portion of the lower surface of the fourth insulation pattern 240.

Alternatively, respective entire portions of lower surfaces of some of the fourth insulation patterns 240 may contact the upper surface of the bit line structure 490, while only respective central portions of lower surface of others of the fourth insulation patterns 240 may contact the upper surface of the bit line structure 490.

FIG. 1 shows that the third insulation pattern 230 is disposed between the bit line structure 490 and the edge portion of the lower surface of the fourth insulation pattern 240.

In example embodiments, an upper surface of the fourth insulation pattern 240 may be substantially coplanar with an upper surface of the second capping pattern 250 in the third direction D3.

The third insulation pattern 230 may include an oxide, e.g., silicon oxide, and the fourth insulation pattern 240 may include an insulating nitride, e.g., silicon nitride.

The semiconductor pattern 102 may be disposed on a portion of the first region I of the second substrate 600 adjacent to the second region II thereof, and may contact the upper surfaces of the bit line structure 490 and the third insulating interlayer 500. The semiconductor pattern 102 may extend in the first direction D1, and may contact a sidewall in the second direction D2 of the first gate insulation pattern 155.

In example embodiments, the semiconductor pattern 102 may include a material substantially the same as that of the channel 105, e.g., a semiconductor material such as silicon, germanium, silicon-germanium, etc.

The first etch stop pattern 125 may be disposed on the second region II of the second substrate 600, and may contact the upper surface of the third insulating interlayer 500. In example embodiments, a lower surface of the first etch stop pattern 125 may be substantially coplanar with lower surfaces of the semiconductor pattern 102, the channel 105, the third and fourth capping patterns 440 and 450 and the first and second gate insulation patterns 155 and 215 in the third direction D3.

In example embodiments, the first etch stop pattern 125 may include a first portion contacting the upper surface of the third insulating interlayer 500 and having a flat plate shape extending in the horizontal direction, and a second portion having a flat pate shape extending from the first portion in the third direction D3 and contacting a sidewall of the semiconductor pattern 102 in the second direction D2. Thus, a cross-section of the first etch stop pattern 125 cut along a plane defined by the second and third directions D2 and D3 may have an "L" shape.

In an example embodiment, an upper surface of the second portion of the first etch stop pattern 125 may be concave upwardly. Thus, an edge portion of the first etch stop pattern 125 may be substantially coplanar with upper surfaces of the semiconductor pattern 102 and the second insulation pattern 130 in the third direction D3, while a central portion of the first etch stop pattern 125 may be lower than the upper surfaces of the semiconductor pattern 102 and the second insulation pattern 130 relative to the upper surface of the second substrate 600.

Alternatively, the upper surface of the second portion of the first etch stop pattern 125 may be substantially flat, and thus an entire portion of the first etch stop pattern 125 may be substantially coplanar with the upper surfaces of the semiconductor pattern 102 and the second insulation pattern 130 in the third direction D3.

The first etch stop pattern 125 may include an insulating nitride, e.g., silicon nitride.

The second insulation pattern 130 may be disposed on the first etch stop pattern 125 on the second region II of the second substrate 600. The second insulation pattern 130 may include an oxide, e.g., silicon oxide.

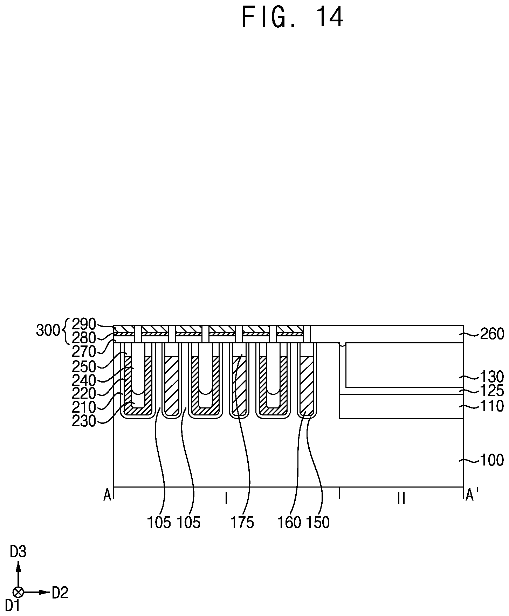

Referring to FIG. 1 together with FIGS. 13 and 14, the first contact plug 270 may contact an upper surface of each of the channels 105, and the landing pad structure 300 may contact an upper surface of the first contact plug 270. Thus, a plurality of first contact plugs 270 may be spaced apart from each other in each of the first and second directions D1 and D2, and a plurality of landing pad structures 300 may be spaced apart from each other in each of the first and second directions D1 and D2, which may be arranged in a lattice pattern or a honeycomb pattern in a plan view.

The first contact plug 270 may contact upper surfaces of portions of the first and second gate insulation patterns 155 and 215 and the second capping pattern 250 adjacent to each of the channels 105 in the second direction D2, and upper surfaces of portions of the fourth insulation pattern 240 and the first capping pattern 175 adjacent to each of the channels 105 in the second direction D2.

The landing pad structure 300 may include first and second conductive patterns 280 and 290 sequentially stacked in the third direction D3.

The first contact plug 270 may include, e.g., doped polysilicon, the first conductive pattern 280 may include a metal silicide, e.g., titanium silicide, tungsten silicide, etc., and the second conductive pattern 290 may include a metal, e.g., tungsten, titanium, etc., or a metal nitride, e.g., titanium nitride.

The first insulating interlayer 260 may be disposed on the second insulation pattern 130, the first etch stop pattern 125, the semiconductor pattern 102, the channel 105, the first and second gate insulation patterns 155 and 215, the first and second capping patterns 175 and 250 and the fourth insulation pattern 240, and may cover sidewalls of the first contact plug 270 and the landing pad structure 300. The first insulating interlayer 260 may include, e.g., silicon oxide, silicon nitride, a low-k dielectric material.

The second etch stop layer 310 may be disposed on the first region I of the second substrate 600, and may contact upper surfaces of the landing pad structure 300 and the first insulating interlayer 260. The second etch stop layer 310 may include an insulating nitride, e.g., silicon boronitride.

The capacitor 360 may include a first capacitor electrode 330, a dielectric layer 340 and a second capacitor electrode 350.

The first capacitor electrode 330 may contact the upper surface of each of the landing pad structures 300, and may extend in the third direction D3 to a given length. Thus, a plurality of first capacitor electrodes 330 may be spaced apart from each other in each of the first and second directions D1 and D2. In example embodiments, the first capacitor electrodes 330 may be arranged in a lattice pattern or a honeycomb pattern in a plan view.

Each of the first capacitor electrodes 330 may extend through the second etch stop layer 310, and the support layer 320 may be disposed on a sidewall of the first capacitor electrode 330. In example embodiments, a plurality of support layers 320 may be spaced apart from each other in the third direction D3 on the sidewall of each of the first capacitor electrodes 330.

The dielectric layer 340 may be disposed on a sidewall of the first capacitor electrode 330, lower and upper surfaces and a sidewall of the support layer 320, and an upper surface and a sidewall of the second etch stop layer 310. The second capacitor electrode 350 may be disposed between a subset of the support layers 320 neighboring in the third direction D3 and between a lowermost one of the support layers 320 and the second etch stop layer 310, and lower and upper surfaces and a sidewall of the second capacitor electrode 350 may be covered by the dielectric layer 340.

The plate electrode 370 may surround upper surfaces and sidewalls of the capacitor 360, the support layer 320 and the second etch stop layer 310.

Each of the first and second capacitor electrodes 330 and 350 may include, e.g., a metal, a metal nitride, a metal silicide, etc., and the dielectric layer 340 may include, e.g., a metal oxide. The support layer 320 may include an insulating nitride, e.g., silicon nitride. The plate electrode 370 may include, e.g., doped silicon-germanium, or a metal such as tungsten.

The first conductive pad 375 may contact the upper surface of the first insulating interlayer 260 on the second region II of the second substrate 600. In an example embodiment, the first conductive pad 375 may include substantially the same material as the plate electrode 370, however, the inventive concept is not limited thereto.

The second and third through vias 514 and 516 may extend through the third insulating interlayer 500, the first etch stop pattern 125, the second insulation pattern 130 and the first insulating interlayer 260, and may contact respective lower surfaces of the plate electrode 370 and the first conductive pad 375. In example embodiments, each of the second and third through vias 514 and 516 may have a horizontal width gradually decreasing from a bottom toward at top thereof in the third direction D3 (i.e., extending upwardly away from the upper surface of the second substrate 600).

The first through via 390 may contact an upper surface of the first conductive pad 375, and may extend in the third direction D3. In example embodiments, the first through via 390 may have a horizontal width gradually increasing from a bottom toward at top thereof in the third direction D3.

The second conductive pad 400 may contact an upper surface of the first through via 390. The second conductive pad 400 may be electrically connected to an upper wiring that may apply input/output signals.

Each of the first to third through vias 390, 514 and 516 and the second conductive pad 400 may include a conductive material, e.g., a metal, a metal nitride, a metal silicide, etc.

The second insulating interlayer 380 may be disposed on the first insulating interlayer 260 and the landing pad structure 300, and may cover upper surfaces and sidewalls of the plate electrode 370 and the first conductive pad 375 and sidewalls of the first through via 390 and the second conductive pad 400. The second insulating interlayer 380 may include, e.g., silicon oxide, silicon nitride, a low-k dielectric material.

In the semiconductor device, the third conductive pattern 460 of the bit line structure 490 and the first contact plug 270 may serve as source/drain layers, respectively, and current may flow in the third direction D3 in the channel 105 between the source/drain layers. Thus, the semiconductor device may include a vertical channel transistor (VCT) having a vertical channel.

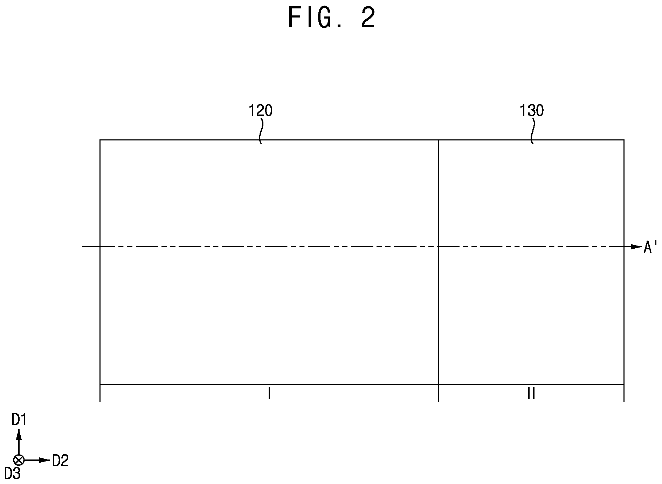

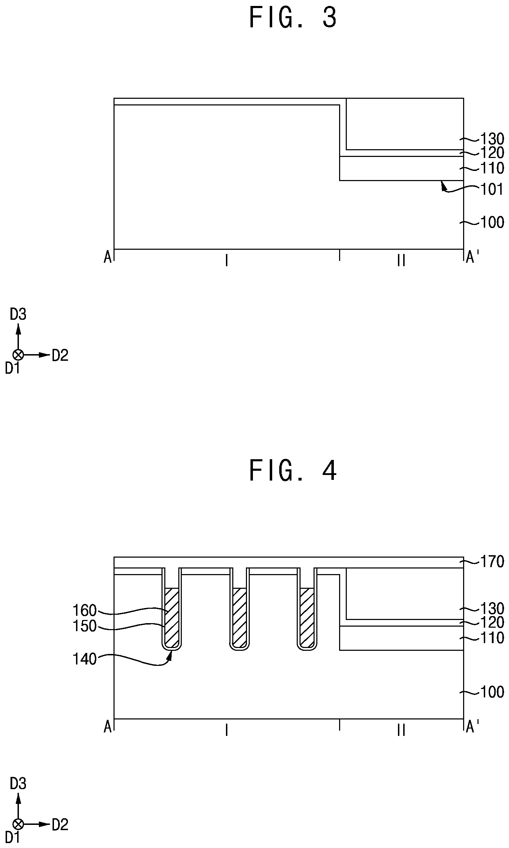

FIGS. 2 to 21 are schematic plan views and cross-sectional views illustrating intermediate processes in a method of manufacturing a semiconductor device in accordance with example embodiments. Specifically, FIGS. 2, 5, 7, 9, 11, 13, 17 and 19 are the schematic plan views, and FIGS. 3-4, 6, 8, 10, 12, 14-16, 18 and 20-21 are schematic cross-sectional views taken along lines A-A' of the corresponding plan views, respectively.

Referring to FIGS. 2 and 3, an upper portion of a second region II of a first substrate 100 including a first region I and the second region II may be removed to form a first trench 101, a first insulation pattern 110 may be formed in a lower portion of the first trench 101, a first etch stop layer 120 may be formed on an upper surface and a sidewall of the first substrate 100 and an upper surface of the first insulation pattern 110, and a second insulation pattern 130 may be formed on the first etch stop layer 120.

The first insulation pattern 110 may be formed by forming a first insulation layer on the first and second regions I and II of the first substrate 100 having the first trench 101 thereon, and performing an etch back process on the first insulation layer to remove an upper portion of the first insulation layer. The first insulation pattern 110 may include an oxide, e.g., silicon oxide, and the first etch stop layer 120 may include an insulating nitride, e.g., silicon nitride.

The second insulation pattern 130 may be formed by forming a second insulation layer on the first etch stop layer 120, and performing a planarization process, e.g., a chemical mechanical polishing (CMP) process on the second insulation layer until an upper surface of a portion of the first etch stop layer 120 on the first region I of the first substrate 100 is exposed. Thus, an upper surface of the second insulation pattern 130 may be substantially coplanar with the upper surface of the portion of the first etch stop layer 120 on the first region I of the first substrate 100.

Referring to FIG. 4, the upper portion of the first etch stop layer 120 on the first etch stop layer 120 and an upper portion of the first region I of the first substrate 100 thereunder may be partially removed to form a second trench 140, a first gate insulation layer 150 may be formed on an inner wall of the second trench 140, an upper surface of the first etch stop layer 120 and an upper surface of the second insulation pattern 130, a first gate electrode layer may be formed on the first gate insulation layer 150 to at least partially fill the second trench 140, and a planarization process, e.g., a CMP process may be performed on the first gate electrode layer and the first gate insulation layer until the upper surfaces of the first etch stop layer 120 and the second insulation pattern 130 are exposed. The term "fill" (or "filling," or like terms) is intended to refer to either completely filling a defined space (e.g., the second trench 140) or partially filling the defined space; that is, the defined space need not be entirely filled but may, for example, be partially filled or have voids or other spaces throughout.

Thus, the first gate insulation layer 150 may remain on the inner wall of the second trench 140, and a first gate electrode 160 may be formed in the second trench 140. The first gate insulation layer 150 may be deposited to conformally cover the inner wall of the second trench 140. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied. In example embodiments, the second trench 140 may extend in the first direction D1 on the first region I of the first substrate 100, and a plurality of second trenches 140 may be spaced apart from each other in the second direction D2. A cross-section of the first gate insulation layer 150 taken along a plane defined by the second and third directions D2 and D3 may have a "U" shape.

An upper portion of the first gate electrode 160 may be removed by, e.g., an etch back process to form a first recess, and a first capping layer 170 may be formed on the first gate electrode 160, the first gate insulation layer 150, the first etch stop layer 120 and the second insulation pattern 130 to fill the first recess.

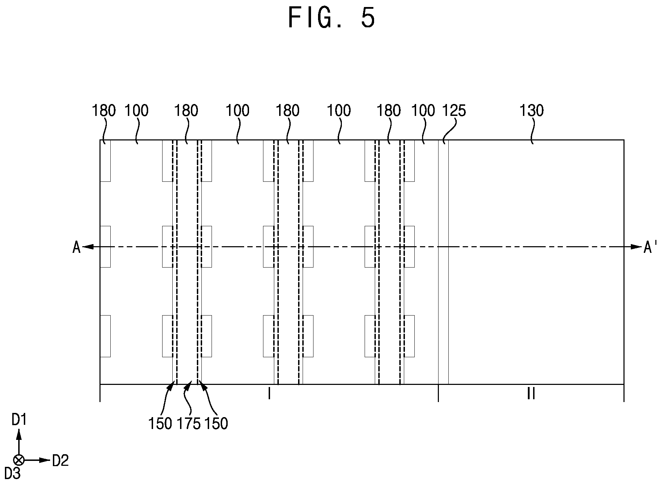

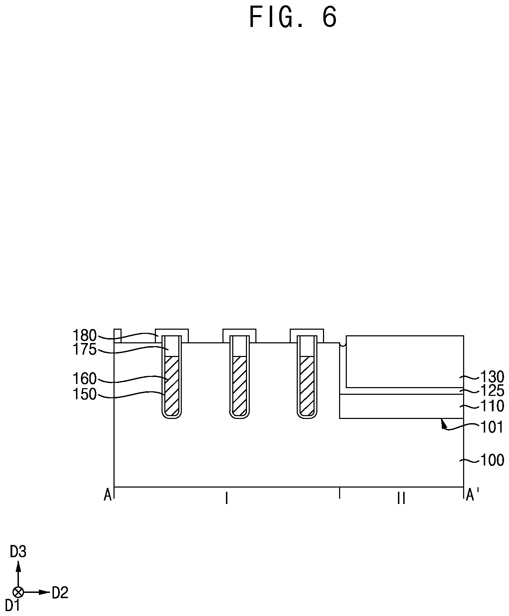

Referring to FIGS. 5 and 6, an upper portion of the first capping layer 170 (see FIG. 4) may be removed by, e.g., a CMP process and/or an etch back process to expose the upper surface of the first etch stop layer 120, an uppermost surface of the first gate insulation layer 150 and the upper surface of the second insulation pattern 130, and a first capping pattern 175 may be formed in the first recess. The term "expose" (or "exposed," or like terms) may be used herein to describe relationships between elements and/or with reference to intermediate processes in fabricating a semiconductor device, but may not require exposure of a particular element in the completed device. Likewise, the term "not exposed" may be used to described relationships between elements and/or with reference to intermediate processes in fabricating a semiconductor device, but may not require a particular element to be unexposed in the completed device.

For example, a wet etching process may be performed to remove a portion of first etch stop layer 120 on the first region I of the first substrate 100 and a portion of the first etch stop layer 120 on a portion of the second region II of the first substrate 100 adjacent to the first region I thereof, and thus a first etch stop pattern 125 may remain on the second region II of the first substrate 100. By the wet etching process, an upper surface of the first region I of the first substrate 100 and an upper sidewall of the first gate insulation layer 150 may be exposed.

In example embodiments, an uppermost surface of a portion of the first etch stop pattern 125 on the portion of the second region II of the first substrate 100 adjacent to the first region I thereof may be concave upwardly due to the characteristic of the wet etching process.

A spacer layer may be formed on the first substrate 100, the first gate insulation layer 150, the first capping pattern 175, the first etch stop pattern 125 and the second insulation pattern 130, and may be partially etched to form a preliminary spacer 180. In example embodiments, the preliminary spacer 180 may cover an upper surface of the first capping pattern 175 and an uppermost surface of the first gate insulation layer 150, and may also cover an upper sidewall of a portion of the first gate insulation layer 150 and an upper surface of a portion of the first substrate 100 adjacent to the portion of the first gate insulation layer 150.

In example embodiments, the preliminary spacer 180 may extend in the first direction D1 on the first region I of the first substrate 100, and a plurality of preliminary spacers 180 may be spaced apart from each other in the second direction D2. Each of opposite sidewalls in the second direction D2 of the preliminary spacer 180 may not be formed in a straight line but may have, for example, a zigzag pattern in the first direction D1.

The preliminary spacer 180 may include an oxide, e.g., silicon oxide.

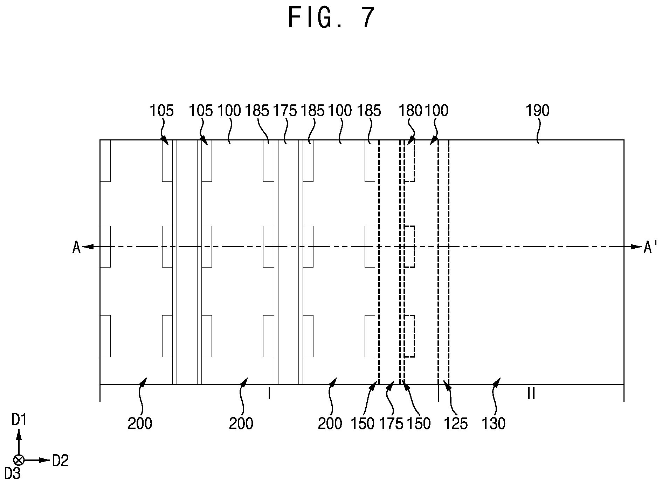

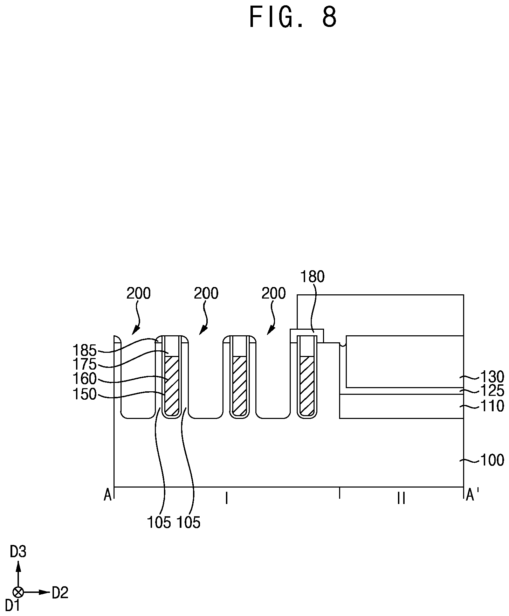

Referring to FIGS. 7 and 8, a mask 190 covering the second region II of the first substrate 100, a portion of the first region I of the first substrate 100 adjacent to the second region II thereof, and the first capping pattern 175, the first gate insulation layer 150 and the preliminary spacer 180 adjacent thereto may be formed.

The mask 190 may include, e.g., a photoresist layer.

An anisotropic etching process may be performed on the preliminary spacers 180 on other portions of the first region I of the first substrate 100 to form a spacer 185 on the upper sidewall of the first gate insulation layer 150, and an etching process may be performed using the spacer 185, the first capping pattern 175, the first gate insulation layer 150 and the mask 190 as an etching mask to partially remove the upper portion of the first substrate 100 so that a third trench 200 may be formed.

In example embodiments, the third trench 200 may extend in the first direction D1, and a plurality of third trenches 200 may be spaced apart from each other in the second direction D2. Each of opposite sidewalls in the second direction D2 of the third trench 200 may not be formed in a straight line but may have a zigzag pattern in the first direction D1.

That is, a width in the second direction D2 of the third trench 200 may not be uniform in the first direction D1, and may periodically vary in the first direction D1. Each of opposite sidewalls in the second direction D2 of a portion of the third trench 200 having a relatively large width in the second direction D2 may expose a sidewall of the first gate insulation layer 150. A channel 105 may be formed between each of opposite sidewalls in the second direction D2 of a portion of the third trench 200 having a relatively small width in the second direction D2 and the first gate insulation layer 150.

In example embodiments, a plurality of channels 105 may be spaced apart from each other in the first direction D1 on a sidewall of the first gate insulation layer 150.

In an example embodiment, a bottom of the third trench 200 may be substantially coplanar with a lower surface of the first gate insulation layer 150 in the third direction D3, however, the inventive concept is not limited thereto.

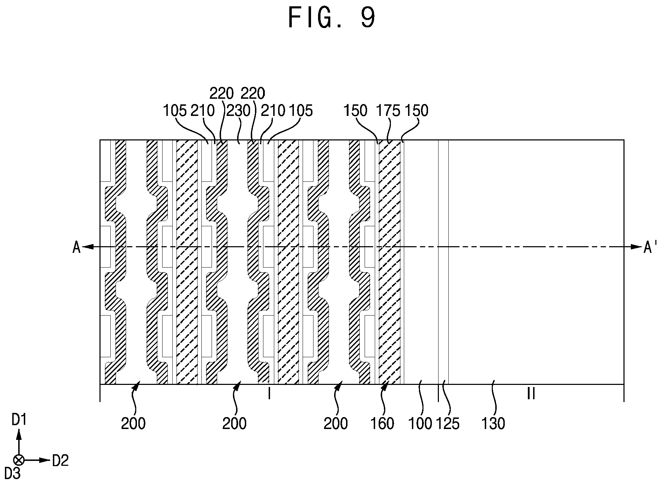

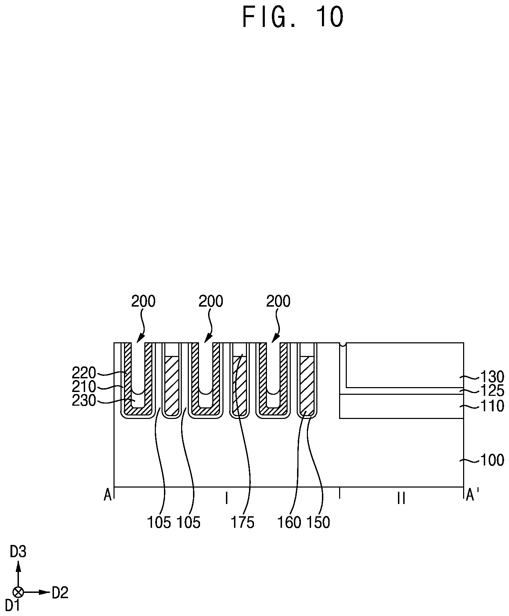

Referring to FIGS. 9 and 10, the mask 190 may be removed by, e.g., an ashing process and/or a stripping process, and a second gate insulation layer 210 and a second gate electrode layer 220 may be sequentially stacked on an inner wall of the third trench 200, a surface of the spacer 185, the uppermost surface of the first gate insulation layer 150, the upper surface of the first capping pattern 175, an upper surface and a sidewall of the preliminary spacer 180, the upper surface of the portion of the first region I of the first substrate 100 adjacent to the second region II thereof, the uppermost surface of the first etch stop pattern 125 and the upper surface of the second insulation pattern 130.

A third insulation layer may be formed on the second gate electrode layer 220 to fill the third trench 200, and a planarization process, e.g., a CMP process may be performed on the third insulation layer, the second gate electrode layer 220 and the second gate insulation layer 210 until the upper surface of the first substrate 100 is exposed.

Thus, the second gate insulation layer 210 and the second gate electrode layer 220 may remain on the inner wall of the third trench 200, and a third insulation pattern 230 may be formed in the third trench 200. A cross-section of each of the second gate insulation layer 210 and the second gate electrode layer 220 taken along a plane defined by the second and third directions D2 and D3 may have a "U" shape. The third insulation layer may include an oxide, e.g., silicon oxide.

During the planarization process, the spacer 185 and the preliminary spacer 180 (see FIG. 8) may be removed, and upper portions of the first capping pattern 175, the first gate insulation layer 150 and the second insulation pattern 130 may also be removed.

In an example embodiment, the uppermost surface of the first etch stop pattern 125 may be concave even after the planarization process, which is shown in FIG. 10. Alternatively, the uppermost surface of the first etch stop pattern 125 may be planarized during the planarization process so as to be substantially flat and coplanar with the upper surfaces of the first substrate 100 and the second insulation pattern 130.

In example embodiments, the second gate insulation layer 210 may extend in the first direction D1, and may cover a sidewall in the second direction D2 of the first gate insulation layer 150 and a sidewall in the second direction D2 and opposite sidewalls in the first direction D1 of the channel 105. Additionally, the second gate electrode layer 220 may extend in the first direction D1, and may cover a sidewall of the second gate insulation layer 150. In example embodiments, each of the second gate insulation layer 210 and the second gate electrode layer 220 may not be formed in a straight line in the first direction D1 but may have a zigzag shape when viewed in a plan view.

An upper portion of the third insulation layer 230 may be removed by, e.g., an etch back process, and thus the third insulation pattern 230 may remain in a lower portion of the third trench 200. Alternatively, the third insulation pattern 230 may be formed by a bottom-up growth process from a surface of the second gate electrode layer 220.

In example embodiments, an upper surface of the third insulation pattern 230 may be concave upwardly, and an upper surface of a central portion or an edge portion of the third insulation pattern 230 may be substantially coplanar with a lower surface of the first etch stop pattern 125.

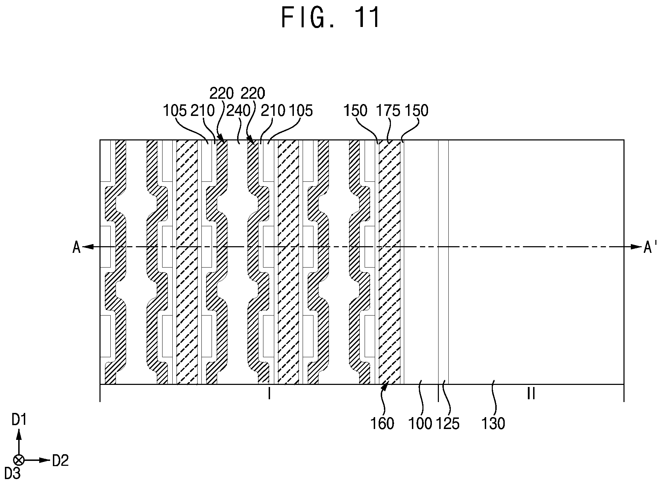

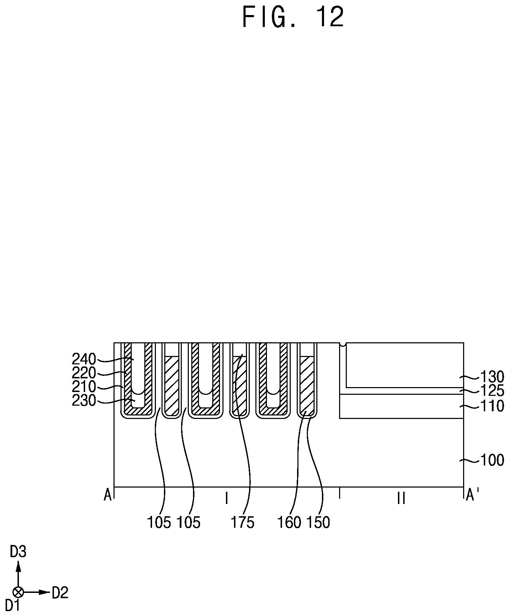

Referring to FIGS. 11 and 12, a fourth insulation pattern 240 may be formed in an upper portion of the third trench 200, an upper portion of the second gate electrode layer 220 may be removed to form a second recess, and a second capping pattern 250 may be formed in the second recess.

In example embodiments, a lower surface of the fourth insulation pattern 240 may be convex downwardly according to the shape of the upper surface of the third insulation pattern 230. In an example embodiment, a lowermost surface of the fourth insulation pattern 240 may be substantially coplanar with the lower surface of the first etch stop pattern 125, however, the inventive concept is not limited thereto.

In example embodiments, the fourth insulation pattern 240 may include a material having an etching selectivity with reference to the third insulation pattern 230, e.g., an insulating nitride such as silicon nitride.

In an example embodiment, a lower surface of the second capping pattern 250 may be substantially coplanar with the lower surface of the first capping pattern 175, however, the inventive concept is not limited thereto.

Referring to FIGS. 13 and 14, a contact plug layer and a landing pad structure layer may be sequentially formed on the first and second capping patterns 175 and 250, the first and second gate insulation layers 150 and 210, the fourth insulation pattern 240, the channel 105, the first etch stop pattern 125 and the second insulation pattern 130, the contact plug layer and the landing pad structure layer may be patterned to form a first contact plug 270 and a landing pad structure 300, respectively, which may contact an upper surface of the channel 105 and an upper surface of the first contact plug 270, respectively, and a first insulating interlayer 260 may be formed to cover sidewalls of the first contact plug 270 and the landing pad structure 300.

The first contact plug 270 may contact not only the upper surface of the channel 105 but also upper surfaces of the first and second gate insulation layers 150 and 210, respectively, and the second capping pattern 250 at opposite sides of the channel 105 in the second direction D2, and upper surfaces of portions of the first capping pattern 175 and the fourth insulation pattern 240.

The landing pad structure 300 may include first and second conductive patterns 280 and 290 stacked in the third direction D3.

In example embodiments, a plurality of first contact plugs 270 may be spaced apart from each other in each of the first and second directions D1 and D2 and a plurality of landing pad structures 300 may be spaced apart from each other in each of the first and second directions D1 and D2 on the first region I of the first substrate 100. The first contact plugs 270 and the landing pad structures 300 may be arranged in a lattice pattern or a honeycomb pattern in a plan view.

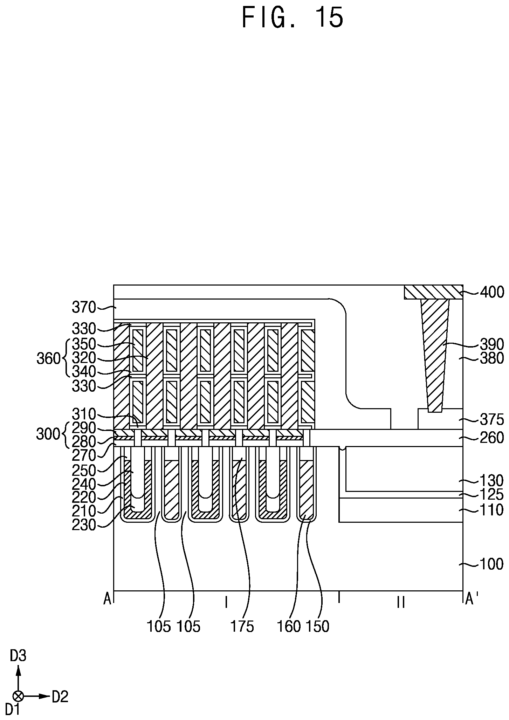

Referring to FIG. 15, a capacitor 360 and a plate electrode 370 may be formed on the first insulating interlayer 260 and the landing pad structure 300.

The capacitor 360 and the plate electrode 370 may be formed by following processes.

A second etch stop layer 310 may be formed on the first insulating interlayer 260, the landing pad structure 300 and the first insulating interlayer 260, and a mold layer and a support layer 320 may be alternately and repeatedly stacked on the second etch stop layer 310.

First openings, which may extend through the mold layer and the second etch stop layer 310 to expose upper surfaces of the landing pad structures, respectively, may be formed on the first region I of the first substrate 100, a first capacitor electrode layer may be formed on the upper surfaces of the landing pad structures 300 exposed by the first openings and an upper surface of an uppermost one of the support layers 320, and a planarization process may be performed on the first capacitor electrode layer until the upper surface of the uppermost one of the support layers 320 is exposed so that a first capacitor electrode 330 may be formed in each of the first openings.

The planarization process may include a CMP process and/or an etch back process.

Portions of the support layer 320 and the mold layer on the second region II of the first substrate 100 may be removed, portions of the support layer 320 and the mold layer on the first region I of the first substrate 100 may be partially removed to form a second opening, and the mold layer may be removed through the second opening.

In example embodiments, the mold layer may be removed by, e.g., a wet etching process, and a third opening may be formed to expose a sidewall of the first capacitor electrode 330 and an upper surface of the second etch stop layer 310. However, the support layers 320 may remain on the sidewall of the first capacitor electrode 330, and thus surfaces of the support layers 320 may also be exposed by the third opening.

A dielectric layer 340 may be formed on sidewalls of the first capacitor electrodes 330, the upper surface of the second etch stop layer 310 and the surfaces of the support layers 320 exposed by the third opening, and a second capacitor electrode layer may be formed on the dielectric layer 340 to fill a remaining portion of the third opening. The dielectric layer 340 and the second capacitor electrode layer may also be stacked on the upper surface of the first capacitor electrode 330 and the upper surface of the uppermost one of the support layers 320.

For example, a wet etching process may be performed on the second capacitor electrode layer to form a second capacitor electrode 350 in the third opening. The first capacitor electrode 330, the dielectric layer 340 and the second capacitor electrode 350 may collectively form a capacitor 360.

The plate electrode 370 may be formed on an upper surface of the capacitor 360 and an upper surface of the first insulating interlayer 260. The plate electrode 230 may be formed on the first region I of the first substrate 100 and a portion of the second region II of the first substrate 100 adjacent thereto, and during the formation of the plate electrode 370, a first conductive pad 375 may be formed on the second region II of the first substrate 100.

A second insulating interlayer 380 may be formed on the first insulating interlayer 260 to cover the plate electrode 370 and the first conductive pad 375, and a first through via 390 and a second conductive pad 400 may be formed in the second insulating interlayer 380.

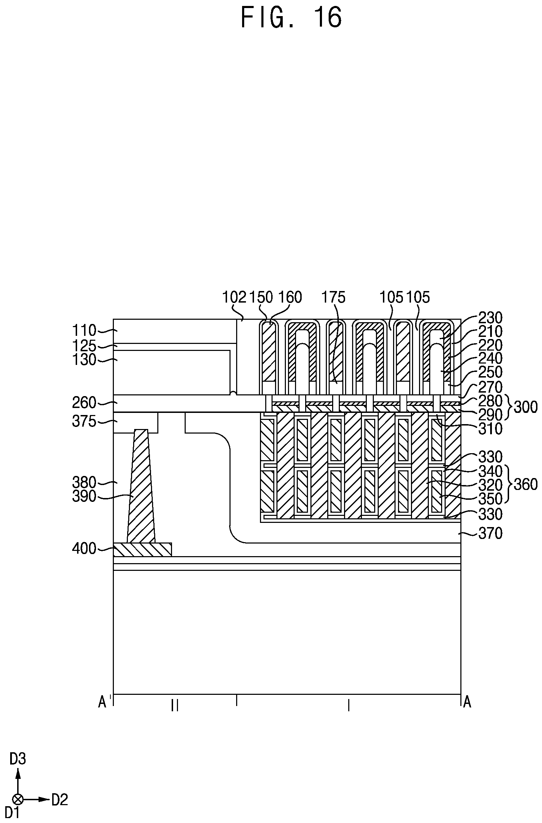

Referring to FIG. 16, a first bonding layer 410 may be formed on the second insulating interlayer 380 and the second conductive pad 400, a second bonding layer 430 may be formed on a handling substrate 420, the first substrate 100 may be flipped, and the first and second bonding layers 410 and 430 may be bonded with each other.

Thus, structures on the first substrate 100 is inverted, flipping its top and bottom, and hereinafter, following explanations are based on this orientation. Additionally, respective portions of the handling substrate 420 overlapping the first and second regions I and II of the first substrate 100 may be referred to as first and second regions I and II, respectively, of the handling substrate 420. The term "overlapping" (or "overlap," or like terms), as may be used herein, is intended to broadly refer to a first element that intersects with at least a portion of a second element in the vertical direction (i.e., third direction D3), but does not require that the first and second elements be completely aligned with one another in a horizontal plane (i.e., first direction D1 and/or second direction D2).

The handling substrate 420 may include a semiconductor material, e.g., silicon or an insulating material, e.g., glass, and each of the first and second bonding layers 410 and 430 may include, e.g., silicon carbonitride, silicon oxide.

An upper portion of the first substrate 100 may be removed by, e.g., a grinding process, and thus upper surfaces of the first insulation pattern 110 and the first and second gate insulation layers 150 and 210 may be exposed. During the grinding process, the first insulation pattern 110 may serve as an end point.

As the grinding process is performed, a lower portion of the first substrate 100 may remain, which may be referred to as a semiconductor pattern 102. The semiconductor pattern 102 may be formed between the first etch stop pattern 125 and the first gate insulation layer 150, and may extend in the first direction D1.

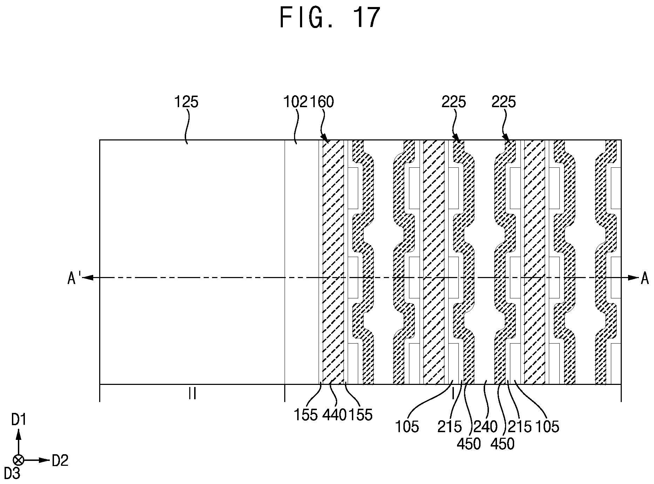

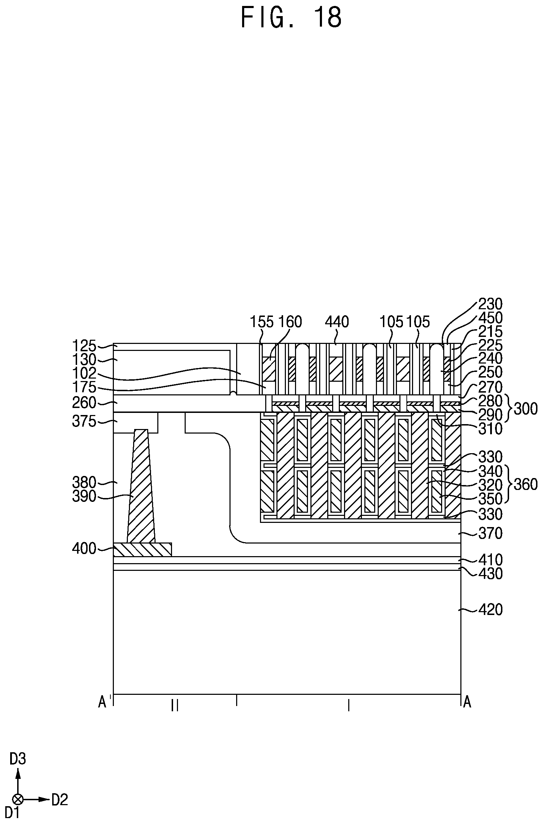

Referring to FIGS. 17 and 18, a planarization process, e.g., a CMP process may be performed to remove the first insulation pattern 110, the third insulation pattern 230, and upper portions of the semiconductor pattern 102, the channel 105, the first and second gate insulation layers 150 and 210, the first gate electrode 160 and the second gate electrode layer 220.

In example embodiments, during the CMP process, the first etch stop pattern 125 may serve as an end point.

As the planarization process is performed, the first and second gate insulation layers 150 and 210 and the second gate electrode layer 220, each of which may have a cross-section of a "U" shape in a plane defined by the second direction D2 and the third direction D3, may be divided into first and second gate insulation patterns 155 and 215 and second gate electrodes 225, respectively, each of which may extend in the third direction D3. The first gate electrode 160 and the first gate insulation pattern 155 may collectively form a first gate structure, and the second gate electrode 225 and the second gate insulation pattern 215 may collectively form a second gate structure.

During the planarization process, the third insulation pattern 230 having a concave lower surface may be entirely or partially removed to expose an upper surface of the fourth insulation pattern 240. FIG. 18 shows that a portion of the fourth insulation pattern 240 remains.

Upper portions of the first and second gate electrodes 160 and 225 may be removed to form third and fourth recesses, respectively, and third and fourth capping patterns 440 and 450 may be formed in the third and fourth recesses, respectively.

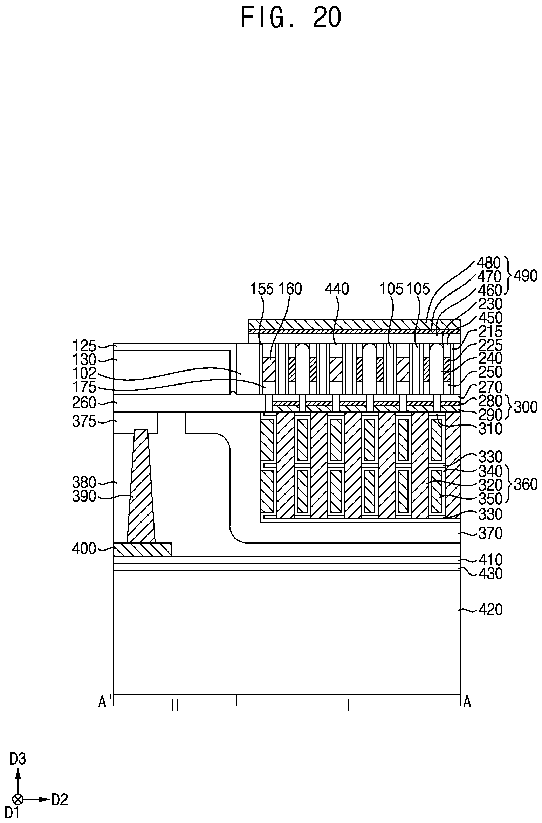

Referring to FIGS. 19 and 20, a bit line structure layer may be formed on the first etch stop pattern 125, the semiconductor pattern 102, the channel 105, the first and second gate electrodes 160 and 225, the first and second gate insulation patterns 155 and 215, the fourth insulation pattern 240, and the third and fourth capping patterns 440 and 450, and may be patterned to form bit line structures 490, each of which may extend in the second direction D2, spaced apart from each other in the first direction D1 on the first region I of the handling substrate 420.

In example embodiments, each of the bit line structures 490 may contact upper surfaces of the channels 105 disposed in the second direction D2, and may also contact upper surfaces of the third and fourth capping patterns 440 and 450, the first and second gate insulation patterns 155 and 215 and the third insulation pattern 240.

In example embodiments, the bit line structure 490 may include third, fourth and fifth conductive patterns 460, 470 and 480, respectively, sequentially stacked in the third direction D3.

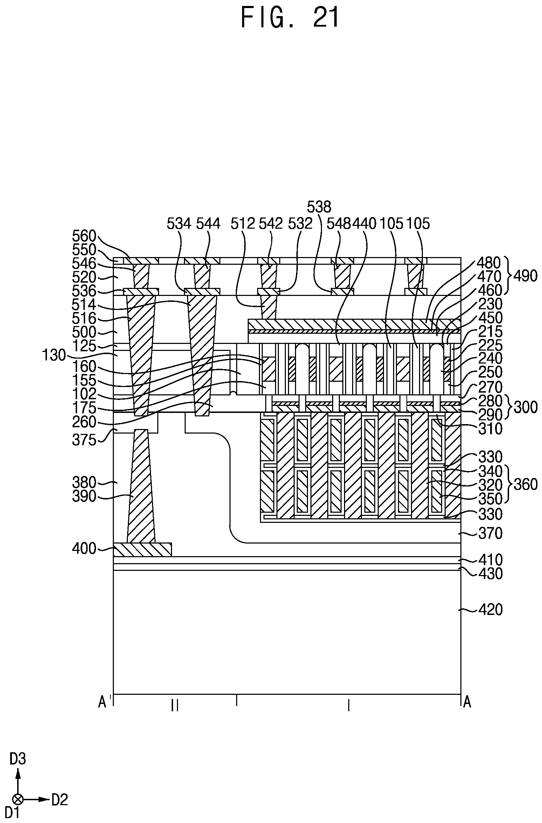

Referring to FIG. 21, a third insulating interlayer 500 may be formed on the first etch stop pattern 125 and the bit line structure 490, and a second contact plug 512 extending in the third direction D3 through the third insulating interlayer 500 to contact an upper surface of the bit line structure 490, and second and third through vias 514 and 516 extending in the third direction D3 through the third insulating interlayer 500, the first etch stop pattern 125 and the second insulation pattern 130 to contact respective upper surfaces of the plate electrode 370 and the first conductive pad 375 may be formed.

First to fourth wirings 532, 534, 536 and 538 and first to fourth vias 542, 544, 546 and 548 may be formed on the third insulating interlayer 500, a fourth insulating interlayer 520 may be formed on the third insulating interlayer 500 to cover the first to fourth wirings 532, 534, 536 and 538 and first to fourth vias 542, 544, 546 and 548, a third bonding layer 550 may be formed on the fourth insulating interlayer 520, and first bonding patterns 560 may be formed through the third bonding layer 550 to contact respective upper surfaces of the first to fourth vias 542, 544, 546 and 548.

Referring to FIG. 1 again and FIG. 21, a peripheral circuit pattern 650 such as a transistor including, e.g., a third gate structure 630 and source/drain layers 605, a wiring structure 660 including, e.g., contact plugs, wirings, vias, etc., and a fifth insulating interlayer 640 covering the peripheral circuit pattern 650 and the wiring structure 660 may be formed on a second substrate 600, a fourth bonding layer 670 may be formed on the fifth insulating interlayer 640, and second bonding patterns 680 extending through the fourth bonding layer 670 to contact respective upper surfaces of the second bonding patterns 680 may be formed.

After flipping the handling substrate 420 upside down, the third bonding layer 550 may be bonded with the fourth bonding layer 670 on the second substrate 600, and the first bonding patterns 560 may contact corresponding ones of the second bonding patterns 680. The handling substrate 420 and the first and second bonding layers 410 and 430 may be removed from the fifth insulating interlayer 640 by, e.g., a grinding process and/or a CMP process to complete the fabrication of the semiconductor device. Portions of the second substrate 600 overlapping the first and second regions I and II, respectively, of the handling substrate 420 may be referred to as first and second regions I and II, respectively, of the second substrate 600.

As illustrated above, the semiconductor device may include the channel 105, which may be formed by partially etching the upper portion of the first substrate 100, and thus the cost for the fabrication of the semiconductor device may be reduced because the expensive SOI substrate is not used.

The first etch stop layer 120, which may be formed on the first region I of the first substrate 100, may also be formed on the second region II of the first substrate 100, and may serve as an end point of the CMP process for removing the upper portion of the second gate electrode layer 220 and the first and second gate insulation layers 150 and 210. Thus, the second gate electrode 225 and the first and second gate insulation patterns 155 and 215 may be substantially coplanar with each other.

Accordingly, the length distribution of the first gate structures, each of which may include the first gate electrode 160 and the first gate insulation pattern 155, and the length distribution of the second gate structures, each of which may include the second gate electrode 225 and the second gate insulation pattern 215 may be reduced, and thus the semiconductor device including the first and second gate structures may have enhanced electrical characteristics.

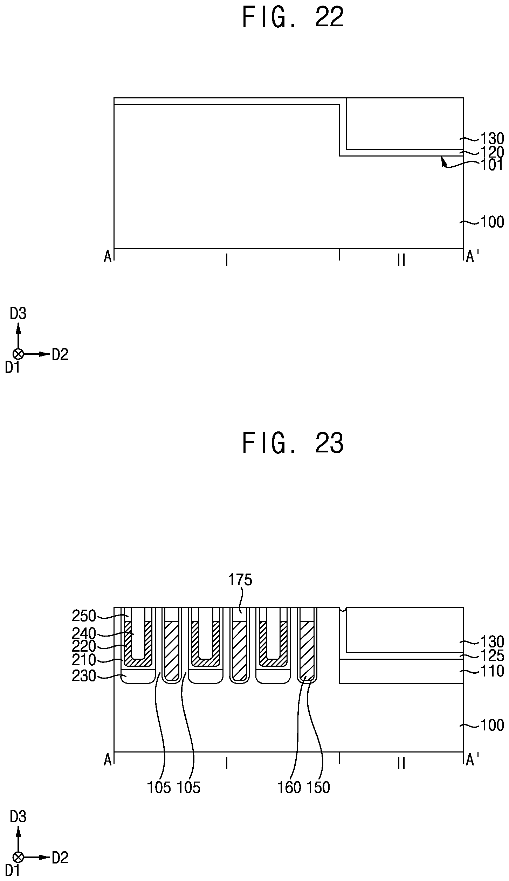

FIG. 22 is a schematic cross-sectional view illustrating a method of manufacturing a semiconductor device in accordance with example embodiments, which may correspond to FIG. 3.

This method may include processes substantially the same as or similar to those illustrated with respect to FIGS. 2 to 21 and FIG. 1, and thus repeated explanations are omitted herein.

Referring to FIG. 22, the upper portion of the second region II of the first substrate 100 including the first and second regions I and II may be removed to form the first trench 101, the first etch stop layer 120 may be formed on the upper surface and the sidewall of the first substrate 100, and the second insulation pattern 130 may be formed on the first etch stop layer 120.

Unlike the processes illustrated with respect to FIGS. 2 and 3, the first insulation pattern 110 (see FIG. 3) filling the lower portion of the first trench 101 may not be formed. A bottom of the first trench 101 shown in FIG. 22 may be lower than a bottom of the first trench 101 shown in FIGS. 2 and 3, relative to a bottom surface of the first substrate 100 as a reference.

Processes substantially the same as or similar to those illustrated with respect to FIGS. 4 to 16 may be performed, and when the upper portion of the first substrate 100 is removed by, e.g., a grinding process, not the first insulation pattern 110 but the upper surfaces of the first and second gate insulation layers 150 and 210 may serve as the end point.

Processes substantially the same as or similar to those illustrated with respect to FIGS. 17 to 21 and FIG. 1 may be performed to complete the fabrication of the semiconductor device.

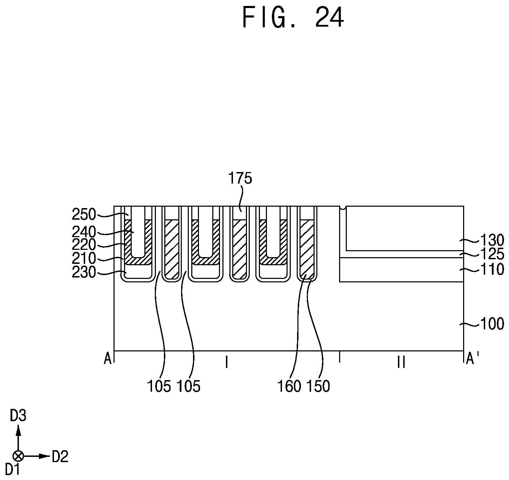

FIGS. 23 and 24 are schematic cross-sectional views illustrating a method of manufacturing a semiconductor device in accordance with example embodiments, which may correspond to FIG. 12.

This method may include processes substantially the same as or similar to those illustrated with respect to FIGS. 2 to 21 and FIG. 1, and thus repeated explanations are omitted herein.

Referring to FIG. 23, processes substantially the same as or similar to those illustrated with respect to FIGS. 2 to 8 may be performed, the mask 190 (see FIG. 8) may be removed, and the third insulation pattern 230 may be formed in a lower portion of the third trench 200 (see FIG. 8).

The second gate insulation layer 210 and the second gate electrode layer 220 may be sequentially stacked on the upper surface of the third insulation pattern 230, an upper inner sidewall of the third trench 200, the surface of the spacer 185, the uppermost surface of the first gate insulation layer 150, the upper surface of the first capping pattern 175, the upper surface and the sidewall of the preliminary spacer 180, the upper surface of the portion of the first region I of the first substrate 100 adjacent to the second region II thereof, the uppermost surface of the first etch stop pattern 125 and the upper surface of the second insulation pattern 130.

A fourth insulation layer may be formed on the second gate electrode layer 220 to fill the third trench 200, and a planarization process may be performed on the fourth insulation layer, the second gate electrode layer 220 and the second gate insulation layer 210 until the upper surface of the first substrate 100 is exposed.

Thus, the second gate insulation layer 210 and the second gate electrode layer 220 may remain on the upper sidewall of the third trench 200 and the upper surface of the third insulation pattern 230, and a fourth insulation pattern 240 may be formed in an upper portion of the third trench 200. During the planarization process, the spacer 185 and the preliminary spacer 180 may be removed, and upper portions of the first capping pattern 175, the first gate insulation layer 150 and the second insulation pattern 130 may also be removed.

In example embodiments, a lower surface of the fourth insulation pattern 240 may be substantially coplanar with the lower surface of the first etch stop pattern 125, relative to the bottom surface of the first substrate 100.

Alternatively, referring to FIG. 24, after removing the mask 190, the second gate insulation layer 210 may be formed on the upper inner sidewall of the third trench 200, the surface of the spacer 185 (see FIG. 8), the uppermost surface of the first gate insulation layer 150, the upper surface of the first capping pattern 175, the upper surface and the sidewall of the preliminary spacer 180, the upper surface of the portion of the first region I of the first substrate 100 adjacent to the second region II thereof, the uppermost surface of the first etch stop pattern 125 and the upper surface of the second insulation pattern 130.

A third insulation pattern 230 may be formed on the second gate insulation layer 210 to fill the lower portion of the third trench 200, the second gate insulation layer 220 may be formed on the upper surface of the third insulation pattern 230 and the upper surface and the sidewall of the second gate insulation layer 210, the fourth insulation layer may be formed on the second gate insulation layer 220 to fill an upper portion of the third trench 200, and a planarization process may be performed on the fourth insulation layer, the second gate electrode layer 220 and the second gate insulation layer 210 until the upper surface of the first substrate 100 is exposed.

Thus, the second gate insulation layer 210 may remain on the inner wall of the third trench 200, the second gate electrode layer 220 may remain on the upper sidewall of the third trench 200 and the upper surface of the third insulation pattern 230, and the fourth insulation pattern 240 may be formed in the upper portion of the third trench 200. During the planarization process, the spacer 185 and the preliminary spacer 180 may be removed, and the upper portions of the first capping pattern 175, the first gate insulation layer 150 and the second insulation pattern 130 may also be removed.

In example embodiments, the lower surface of the fourth insulation pattern 240 may be substantially coplanar with the lower surface of the first etch stop pattern 125, relative to the bottom surface of the first substrate 100.

Processes substantially the same as or similar to those illustrated with respect to FIGS. 13 to 16 may be performed, and a CMP process may be performed to remove the first insulation pattern 110, the third insulation pattern 230, and the upper portions of the semiconductor pattern 102, the channel 105, the first and second gate insulation layers 150 and 210, the first gate electrode 160 and the second gate electrode layer 220. In example embodiments, the first etch stop pattern 125 may serve as an end point during the CMP process.

The upper portions of the first and second gate electrodes 160 and 225 may be removed to form the third and fourth recesses, and the third and fourth capping patterns 440 and 450 may be formed in the third and fourth recesses, respectively.

Processes substantially the same as or similar to those illustrated with respect to FIGS. 19 to 21 and FIG. 1 may be performed to complete the fabrication of the semiconductor device.

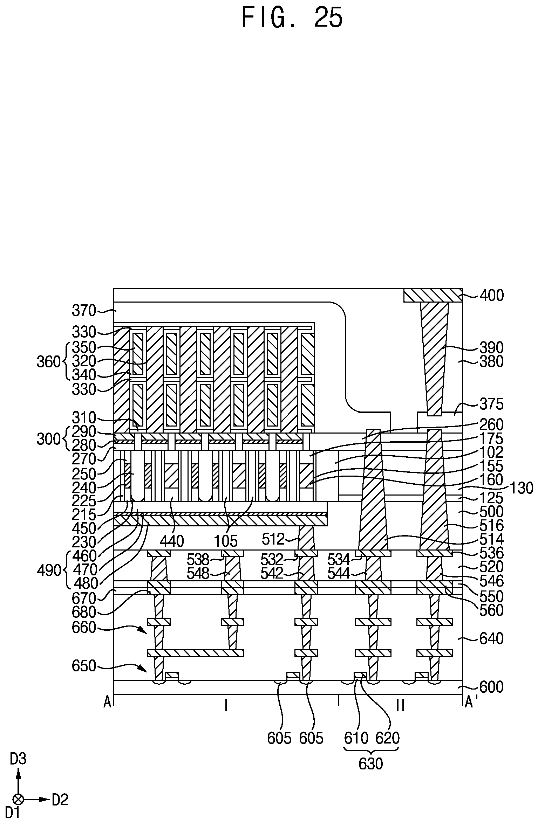

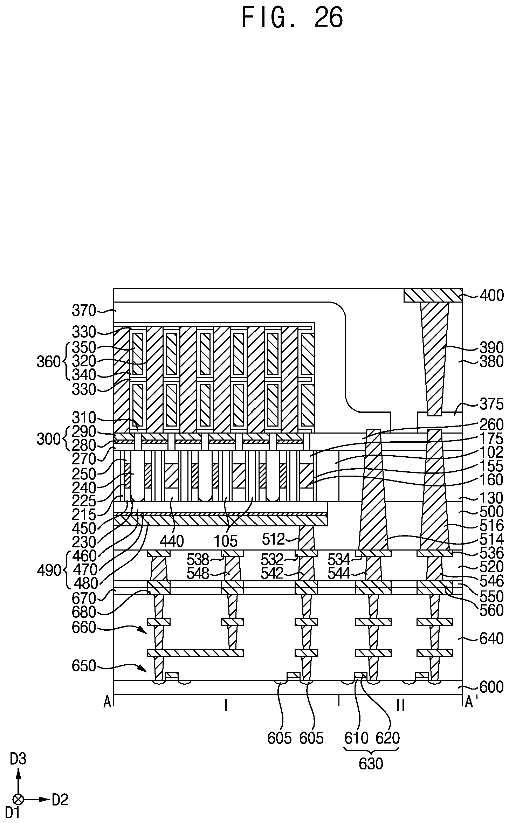

FIGS. 25 and 26 are schematic cross-sectional views illustrating semiconductor devices in accordance with example embodiments, which may correspond to FIG. 1.

These semiconductor devices may be substantially the same as or similar to that of FIG. 1, except for the first etch stop pattern 125 and the second insulation pattern 130, and thus repeated explanations are omitted herein.

Referring to FIG. 25, the first etch stop pattern 125 may include only a first portion contacting the upper surface of the third insulating interlayer 500, and may not include a second portion extending in the third direction D3 from the first portion and contacting the sidewall of the semiconductor pattern 102 in the second direction D2.

Even though the first etch stop pattern 125 does not include the second portion, the first etch stop pattern 125 may serve as the end point during the CMP process illustrated with reference to FIGS. 17 and 18.

Referring to FIG. 26, the semiconductor device may not include the second insulation pattern 130 but include only the first etch stop pattern 125 on the second region II of the second substrate 600.

When the processes illustrated with reference to FIG. 3 are performed, the first insulation pattern 110 may be formed in the lower portion of the first trench 101, and the first etch stop layer 120 may be formed on the surface of the first region I of the first substrate 100 and the first insulation pattern 110, and the first etch stop layer 120 may entirely fill the first trench 101.

Processes substantially the same as or similar to those illustrated with respect to FIGS. 5 and 6 may be performed, so that an upper portion of the first etch stop layer 120 may be removed to form the first etch stop pattern 125, and during the CMP process illustrated with reference to FIGS. 17 and 18, the first etch stop pattern 125 may serve as the end point.

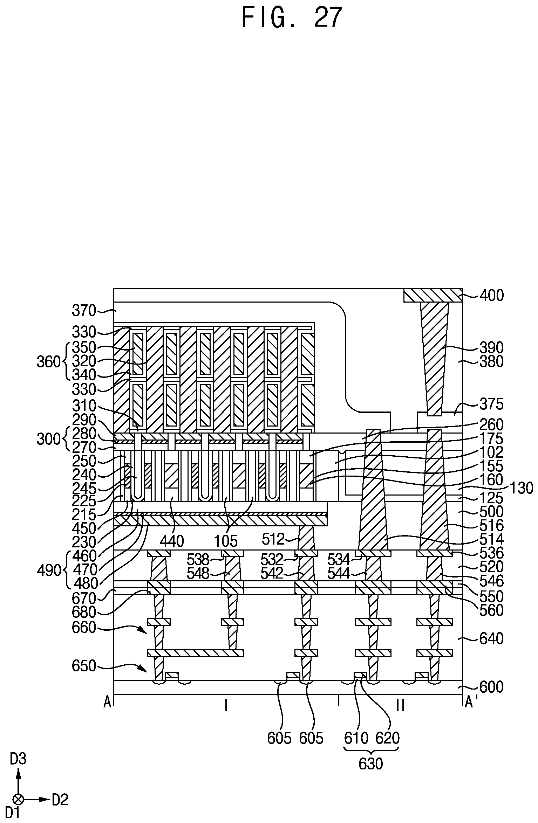

FIG. 27 is a schematic cross-sectional view illustrating a semiconductor device in accordance with example embodiments, which may correspond to FIG. 1.

This semiconductor device may be substantially the same as or similar to that of FIG.1 except for the shape of the fourth insulation pattern and further including a fifth insulation pattern, and thus repeated explanations are omitted herein.

Referring to FIG. 27, a cross-section of the fourth insulation pattern 240 taken along a plane defined by the second and third directions D2 and D3 may have a "U" shape, and a fifth insulation pattern 245 may be further formed on the fourth insulation pattern 240.

In example embodiments, the fifth insulation pattern 245 may include an oxide, e.g., silicon oxide, and thus may have a dielectric constant less than that of the fourth insulation pattern 240 including, e.g., silicon nitride.

Accordingly, a parasitic capacitance between neighboring ones of the second gate electrodes 225 may be reduced.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device, comprising:
a peripheral circuit pattern on a substrate, the substrate including a first region and a second region extending around the first region;
a bit line structure on the peripheral circuit pattern on the first region of the substrate, the bit line structure electrically connected to the peripheral circuit pattern;
a channel on the bit line structure, the channel electrically connected to the bit line structure;
a word line at a first side of the channel;
a capacitor on the channel, the capacitor electrically connected to the channel;
a plate electrode on an upper surface and a sidewall of the capacitor;
an etch stop pattern on the second region of the substrate, a lower surface of the etch stop pattern substantially coplanar with a lower surface of the channel; and
a first through via on the peripheral circuit pattern on the second region of the substrate, the first through via electrically connected to the peripheral circuit pattern, extending through the etch stop pattern in a vertical direction substantially perpendicular to an upper surface of the substrate, and contacting the plate electrode.

2. The semiconductor device according to claim 1, wherein a cross-section in a direction of the etch stop pattern has an "L" shape.

3. The semiconductor device according to claim 1, wherein the etch stop pattern includes:
a first portion that extends in a horizontal direction substantially parallel to the upper surface of the substrate; and
a second portion that extends in the vertical direction.

4. The semiconductor device according to claim 3, wherein an upper surface of the second portion of the etch stop pattern is concave.

5. The semiconductor device according to claim 3, further comprising an insulation pattern on the etch stop pattern, an upper surface of the insulation pattern substantially coplanar with an upper surface of the etch stop pattern.

6. The semiconductor device according to claim 5, wherein the etch stop pattern comprises a nitride, and the insulation pattern comprises an oxide.

7. The semiconductor device according to claim 1, further comprising a back gate electrode at a second side of the channel opposite the first side of the channel.

8. The semiconductor device according to claim 1, further comprising first and second capping patterns contacting upper and lower surfaces, respectively, of the word line,
wherein an upper surface of the first capping pattern is substantially coplanar with an upper surface of the channel, and a lower surface of the second capping pattern is substantially coplanar with a lower surface of the channel.

9. The semiconductor device according to claim 8, further comprising:
a first insulation pattern contacting sidewalls of the word line and the first and second capping patterns and having a lower surface that is convex facing the upper surface of the substrate; and
a second insulation pattern between an upper surface of the bit line structure and a lower surface of an edge portion of the first insulation pattern.

10. The semiconductor device according to claim 9, wherein the first insulation pattern comprises a nitride, and the second insulation pattern comprises an oxide.

11. The semiconductor device according to claim 1, further comprising:
a second through via electrically connected to the peripheral circuit pattern on the second region of the substrate, the second through via extending through the etch stop pattern in the vertical direction; and
a conductive pad on the second through via, the conductive pad electrically connected to the second through via.

12. A semiconductor device, comprising:
a bit line structure on a first region of a substrate, the substrate including the first region and a second region extending around the first region;
an insulating interlayer on a sidewall of the bit line structure;
a channel on the bit line structure, the channel electrically connected to the bit line structure;
a word line at a first side of the channel;
a capacitor on the channel, the capacitor electrically connected to the channel;
an etch stop pattern on the insulating interlayer on the second region of the substrate, a cross-section of the etch stop pattern in a vertical direction substantially perpendicular to an upper surface of the substrate having an "L" shape; and
an insulation pattern on the etch stop pattern, an upper surface of the insulation pattern substantially coplanar with an upper surface of the etch stop pattern, and the insulation pattern including a material different from a material of the etch stop pattern.

13. The semiconductor device according to claim 12, wherein the etch stop pattern comprises:
a first portion contacting an upper surface of the insulating interlayer, the first portion extending in a horizontal direction substantially parallel to the upper surface of the substrate; and
a second portion extending in the vertical direction.

14. The semiconductor device according to claim 12, further comprising a back gate electrode at a second side of the channel opposite the first side of the channel.

15. A semiconductor device, comprising:
a peripheral circuit pattern on a substrate, the substrate including a first region and a second region extending around the first region;
a first insulating interlayer on the substrate, the first insulating interlayer on the peripheral circuit pattern;
a bonding layer structure on the first insulating interlayer, the bonding layer including a bonding pattern structure;
bit line structures on the bonding layer structure on the first region of the substrate, the bit line structures electrically connected to the boding pattern structure, each of the bit line structures extending in a first direction substantially parallel to an upper surface of the substrate, and the bit line structures spaced apart from each other in a second direction substantially parallel to the upper surface of the substrate and crossing the first direction;
a second insulating interlayer on the bonding layer structure, the second insulating interlayer on sidewalls of the bit line structures;
channels contacting an upper surface of each of the bit line structures, the channels spaced apart from each other in the first direction;
first gate structures on the bit line structures and the second insulating interlayer, each of the first gate structures extending in the second direction, and the first gate structures contacting first sidewalls in the first direction of ones of the channels in the second direction;
second gate structures on the bit line structures and the second insulating interlayer, each of the second gate structures extending in the second direction, and the second gate structures contacting second sidewalls in the first direction of the ones of the channels in the second direction;
contact plugs on the channels, respectively;
landing pad structures on the contact plugs, respectively;
a capacitor on the landing pad structures, the capacitor electrically connected to the landing pad structures;
a plate electrode on an upper surface and a sidewall of the capacitor;
an etch stop pattern on the second region of the substrate, the etch stop pattern contacting an upper surface of the second insulating interlayer;
a first insulation pattern on the etch stop pattern; and
a through via on the second region of the substrate, the through via extending through the second insulating interlayer, the etch stop pattern and the first insulation pattern in a vertical direction substantially perpendicular to the upper surface of the substrate, and the through via contacting the plate electrode.
